# EUROPEAN PATENT SPECIFICATION

(11) **EP 1 601 887 B1**
(45) Date of publication and mention of the grant of the patent: **13.08.2008**
(21) Application number: 04716248.2
(22) Date of filing: 02.03.2004
(51) Int. Cl.: F16D 69/02, C04B 35/83, C23C 16/458, C23C 16/44

(54) **ONE PIECE SHIM**
EINTEILIGES ABSTANDSELEMENT
ELEMENT DE COMPENSATION MONOBLOC

(30) Priority: 03.03.2003 US 450678 P
(43) Date of publication of application: 07.12.2005
(73) Proprietor: MESSIER-BUGATTI, 78140 Velizy Villacoublay (FR)
(72) Inventor: CHANG, Kenny, Union, Kentucky (US)
(74) Representative: Joly, Jean-Jacques
(86) International application number: PCT/EP2004/002147
(87) International publication number: WO 2004/077912

(56) References cited:
- EP-A- 0 832 863
- GB-A- 419 949
- GB-A- 1 311 537
- US-B1- 6 284 969

## Description

### Background of the invention:

The present invention relates to shim members used to space apart stacked porous substrates during a manufacturing process. A particular example of the present invention relates to carbon annular shim members used to space apart stacked annular composite material preforms especially during a densification process, such as chemical vapor infiltration (CVI).

The composite material preforms may particularly be annular preforms for making brake disks or other friction members.

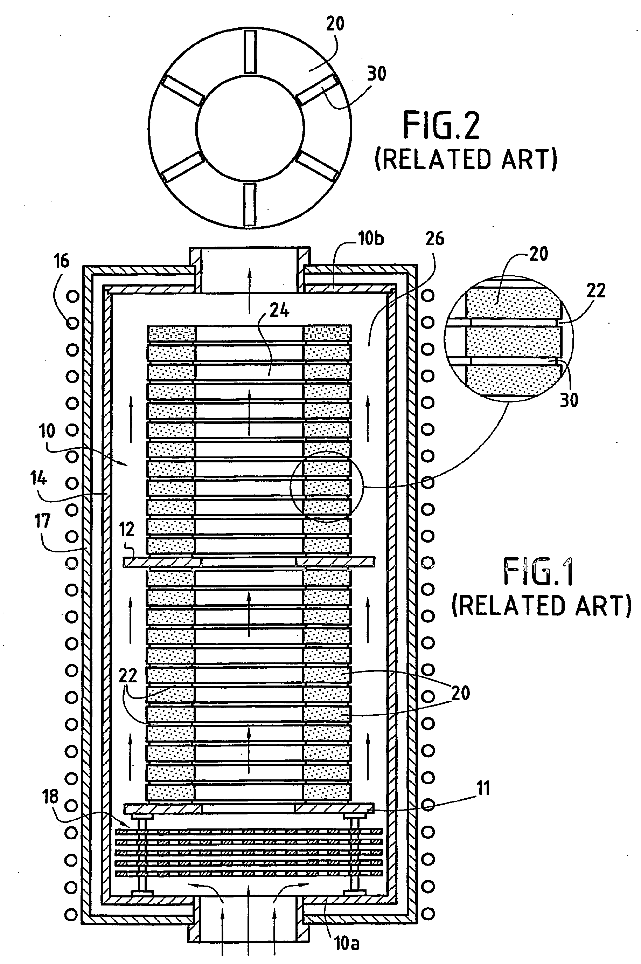

An apparatus for densifying annular preforms to make brake disks and the like is disclosed in, for example, U.S. Patent Application No. 10/468,031 filed on August 14, 2003; a representation thereof is illustrated in Figure 1.

Figure 1 is a highly diagrammatic illustration of a process chamber having an enclosure 10 therein containing a load of annular preforms or substrates 20 made from carbon fiber. The load is in the form of a stack of substrates having their respective central passages generally in vertical alignment. The stack may be made up of a plurality of superposed stack sections separated by one or more intermediate support plates 12.

The stacked substrates are separated from one another by means of spacers 30. As shown in Figure 2, the spacers 30 may be disposed radially, and the number of them may vary. They provide gaps 22 of substantially constant height throughout the entire stack between adjacent substrates, while allowing the inside volume 24 of the stack, as constituted by the generally aligned central passages of the substrates, to communicate with the outer volume 26 situated outside the stack and inside the enclosure 10.

In the example of Figure 1, the enclosure 10 contains a single stack of substrates. In a variant, a plurality of stacks of substrates may be disposed side by side in the same enclosure.

The enclosure 10 is heated by means of a susceptor 14, e.g. made of graphite, which serves to define the enclosure 10 and which is inductively coupled with an induction coil 16 situated outside a casing 17 surrounding the susceptor. Other methods of heating may be used, for example resistive heating (the Joule effect).

A gas containing one or more precursors of carbon, typically hydrocarbon gases such as methane and/or propane, is admitted into the enclosure 10. In the example shown, admission takes place through the bottom 10a of the enclosure. The gas passes through a preheater zone 18 formed by one or more pierced plates disposed one above another in the bottom portion of the enclosure, beneath the plate 11 supporting the stack of substrates. The gas heated by the preheater plates (which are raised to the temperature that exists inside the enclosure) flows freely into the enclosure, passing simultaneously into the inside volume 24, into the outer volume 26, and into the gaps 22. The residual gas is extracted from the enclosure by suction through an outlet formed in the cover 10b.

Spacers 30 are individually placed block members, most usually made from alumina. However, once formed, the alumina block members are very fragile, and losses from breakage are very high. In fact, in normal usage, the conventional alumina blocks frequently last not more than 2 or 3 densification cycles. This naturally raises manufacturing costs, as the alumina blocks must be replaced.

Moreover, the proper manual placement of individual alumina block members between each preform layer is extremely time-consuming. Six such block members are shown in Figure 2 by way of illustrative example, and in actual practice as many as twelve blocks are used. The time burden is exacerbated by the extraordinary care needed to handle the fragile blocks without breakage. In general, a full densification process comprising seven trays of preforms (each with twelve to fourteen preform stacks) can take as long as one or two working days to set up according to the conventional method.

Another problem related to the use of individual spacer members 30 is that they tend to cause deformations (literally, dents) in the preforms caused by the weight of preforms (and spacers) stacked thereabove. As can be appreciated from Figure 2, there are large unsupported areas of the preform circumferentially between the spacer members 30. Because the preform material is generally pliable, and because the alumina constituting spacer members 30 does not deform, indentations occur in the surface of the preforms in locations corresponding to the spacer members 30. These deformations, however slight, must be machined away in an extra finishing step so as to obtain a desirably planar surface usable for friction applications. As a result, the thickness of each preform is thicker than is needed for a final product, in anticipation of the deformations that occur in the known process and of the final machining step to remove those deformations. The machined-away material represents economic waste.

### Summary of the present invention:

In view of the foregoing, the present invention relates to a one-piece or otherwise unitary annular shim member for spacing apart stacked annular preforms.

A shim member according to the present invention has a generally flattened annular form with opposing first and second surfaces. At least one of the surfaces includes is shaped to at least partially define radially extending gas flow paths for communicating the interior space of the shim member with an exterior.

A shim member according to the present invention is preferably similar in radial dimensions to the annular preforms adjacent thereto. That is, the shim member preferably has a similar interior diameter and a similar exterior diameter to the annular preforms. If the shim member is not generally identical in size to the annular preforms, it is preferable to slightly undersize the shim member (i.e., have an interior diameter greater than and/or an exterior diameter less than the annular preforms), rather than have the shim member be larger (i.e., radially wider) than the annular preforms.

In the present invention, the shim member is made from a carbon material (such as graphite or carbon/carbon composite) having a debonding coating formed thereon.

### Brief description of the drawings:

The present invention will be even better understood with reference to the figures attached hereto, in which:
Figure 1 illustrates a process chamber for densifying stacked annular preforms;
Figure 2 illustrates an arrangement of individual spacer members for spacing apart the stacked annular preforms illustrated in Figure 1;
Figures 3a-3c illustrate a first example of a one-piece shim member according to the present invention;
Figures 4a-4c illustrate a second example of a one-piece shim member according to the present invention; and
Figures 5a-5c illustrate a third example of a one-piece shim member according to the present invention.

It is expressly emphasized that the figures herein are meant to merely illustrate examples of the present invention and are not to be construed as limiting the definition thereof in any way. It is also noted that the figures herein are not necessarily to scale, either in general or among interrelated views.

### Detailed description of the present invention:

In general, a shim member according to the present invention has certain fundamentally useful characteristics.

A one-piece or otherwise unitary construction greatly facilitates the loading of a process chamber with stacked annular preforms, in comparison to the use of several individual spacer members between every annular preform in the stack. As noted above, the conventional arrangement described above with reference to Figure 2 requires manual placement of each conventional spacer member. Moreover, because the conventional spacer member is usually made from a highly fragile material such as alumina, each spacer member must be handled with great care during an already lengthy and tedious manual process to try to avoid breakage. The spacer members are also relatively small and very thin (for example, 2.54 x 10.2 x 0.25 cm (1"x4"x0.1") which also makes handling them difficult.

With the use of a one-piece shim member according to the present invention, a single action of positioning the shim member replaces the several placement actions of positioning individual spacer members according to the conventional method. In comparison to the one to two days to load a process chamber in the conventional manner discussed above, the use of a one-piece shim according to the present invention could, on an equal basis, reduce loading times down to two to four hours.

In addition, the structure of the one-piece shim member according to the present invention better supports the weight of the one or more annular preforms stacked thereon over a greater area, in comparison to the conventional use of individual spacer members, as illustrated in Figure 2. In particular, the radial width of the annular one-piece shim member should be about equal to or slightly narrower than that of the annular preforms. As a result, each annular preform is less deformed after being removed from the process chamber. This means that less remedial machining is required after the densification process to obtain a usefully undeformed surface.

As just mentioned, the one-piece shim member preferably has about the same radial width as the annular preform, or is slightly narrower (for example, by about 5 mm with respect to the outside and/or inner diameters thereof). If the one-piece shim member were wider than the annular preform, the exposed portions would tend to have a residue build up (such as pyrolytic carbon) thereon from the decomposition of the densification gas. This would either reduce the useful life of the shim member or entail additional refurbishment procedures to remove such buildup. In addition, if the shim member extended radially outward beyond the outside edge of the annular preforms, it could cause a problem in positioning several annular preform stacks in a process chamber for simultaneous processing (as is frequently done). This would negatively affect production efficiency to the extent that fewer stacks could be processed together because of spacing issues within the process chamber.

In general, the one-piece shim member according to the present invention includes radially extending channels or other features on one or both surfaces thereof that, in net effect, at least partly define gas flow paths communicating the radially interior side of the one-piece shim member with the radially exterior side thereof. The mention of "partly" defined gas flow paths is made here because in some cases, the gas flow paths are also partly defined by the opposing surface of one of the annular preforms in cooperation with the structure of the one-piece shim member. The cross-sectional area of the gas flow paths using the one-piece shim is preferably comparable, in net effect, to the cross-sectional area presented in the prior art arrangement. However, this consideration may vary in accordance with individual situations.

It will be appreciated that the collective cross-sectional area of the gas flow paths presented can be affected, for example, by either adjusting the size of each channel or the like, or by providing more of the channels or the like. A deciding factor in this regard is maintaining a desirable level of support for the overlying annular preform(s).

Generally, the one-piece shim member according to the present invention should be made from a material that can withstand temperatures of up to about 1100°C, and preferably (for safety purposes) up to about 1200°C to 1400°C. The chosen material is preferably minimally reactive with the preform at the operational temperatures mentioned.

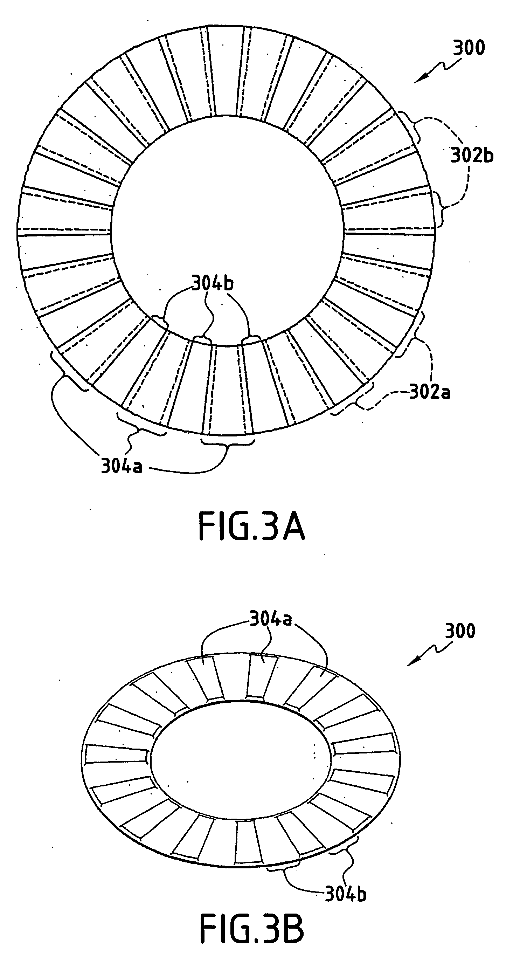

Figures 3a-3c, 4a-4c, and 5a-5c illustrate example geometries of a carbon-based one-piece shim according to the present invention. The constitute material may be, for example, a carbon/carbon material or it may be a very thermally conductive graphite. In the latter case, suitable graphite is commercially available under names such as PGX, UCAR, and MKU-S.

A carbon/carbon material can be made into an annular shim according to the present invention in a known manner from a 2-D or 3-D preform (that may be needled) or laminated from multi-layers of woven carbon fiber fabric, and then densified using a CVI or resin impregnation process.

Carbon/carbon based starting materials can be molded and/or machined into shape in a known manner, and graphite used as a starting material can be machined in a known manner into a desired geometry from a blank.

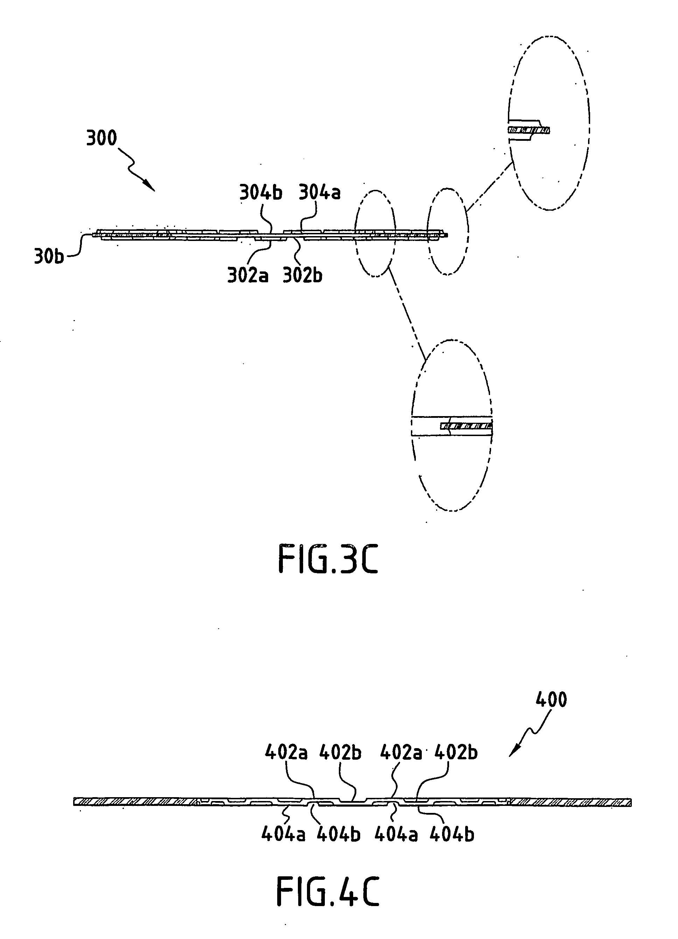

In Figures 3a-3c, Figure 3a is a plan view of an annular shim member 300 according to the present invention. Figure 3b is a perspective view of annular shim member 300. Figure 3c is a cross-sectional elevational view of shim member 300 in a plane perpendicular to a plane in which the annular shim member 300 lies.

Annular shim member 300 has a plurality of spaced apart generally regularly shaped raised portions (some of which are indicated at 304a) alternating with relatively lowered portions therebetween (some of which are indicated at 304b) on one side thereof. Likewise, the other side of annular shim 300 has corresponding spaced apart generally regularly shaped raised portions (some of which are indicated by broken lines at 302a) alternating with relatively lowered portions therebetween (some of which are indicated at 302b).

In this example, edge portions of the raised portions 302a, 304a overlap an edge of a corresponding raised portion on the other side of annular shim member 300. See, for example, Figure 3c. Collectively, they provide a greater weight bearing area than the conventional spacer members 30 mentioned above. Therefore, the weight of the stack is spread over a greater area, and the load is not concentrated in a way that causes the relatively severe impressions in the conventional method corresponding to the location of conventional spacer members 30.

Lowered portions 302b, 304b define radially extending channels or gas flow paths through which the densification gas can flow from an interior of the stacked annular preforms to the exterior. As mentioned above, the collective cross-sectional area that these channels present for densification gas flow may, in general, vary according to a specific processing situation. However, in general, the cross-sectional area should usually be comparable to that presented when using the conventional spacer members 30 mentioned above.

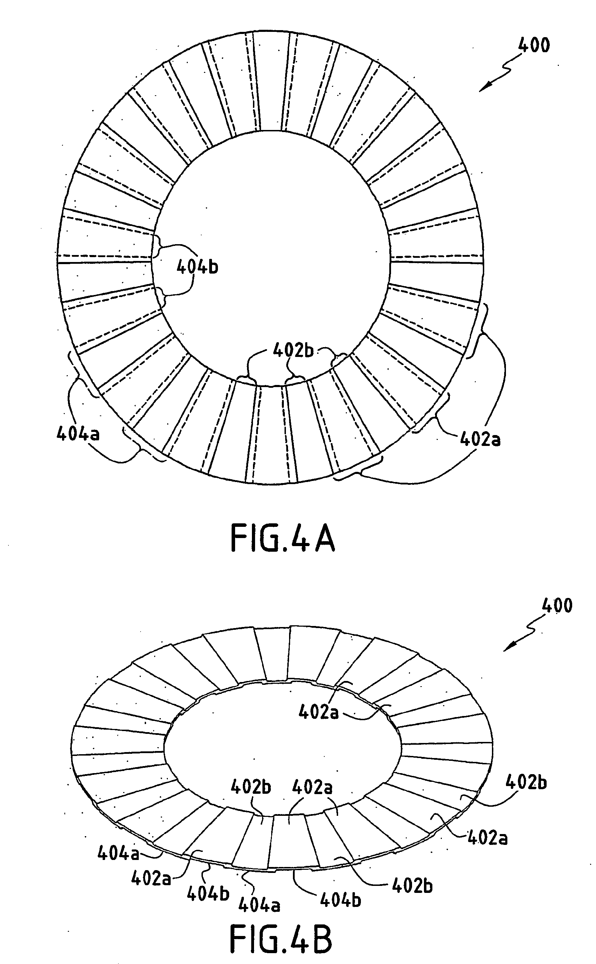

In Figures 4a-4c, Figure 4a is a plan view of an annular shim member 400 according to the present invention. Figure 4b is a perspective view of annular shim member 400. Figure 4c is a cross-sectional elevational view of shim member 400 in a plane perpendicular to a plane in which the annular shim member 400 lies.

Annular shim member 400 has a structure similar to that of annular shim member 300, in that both sides thereof have relatively raised portions 402a, 404a alternating with relatively lowered portions 402b, 404b. Here, again, the relatively lowered portions 402b, 404b define radially extending channels or gas flow passages through which the densification gas can pass from an interior of the stacked annular preforms to an exterior thereof.

It can be seen in Figure 3c that the structure of annular shim member 300 is defined relative to a central planar thickness of the constituent material 306. Thus, one can trace a straight circumferential path about an outside edge of annular shim member 300.

In contrast, because annular shim member 400 is relatively thinner than annular shim member 300, there is no equivalent planar thickness of the constituent material therein. Thus, it is only possible to trace an undulating path (corresponding to the alternating raised and lowered portions) along an outside edge of annular shim member 400. (See, for example, Figure 4c.)

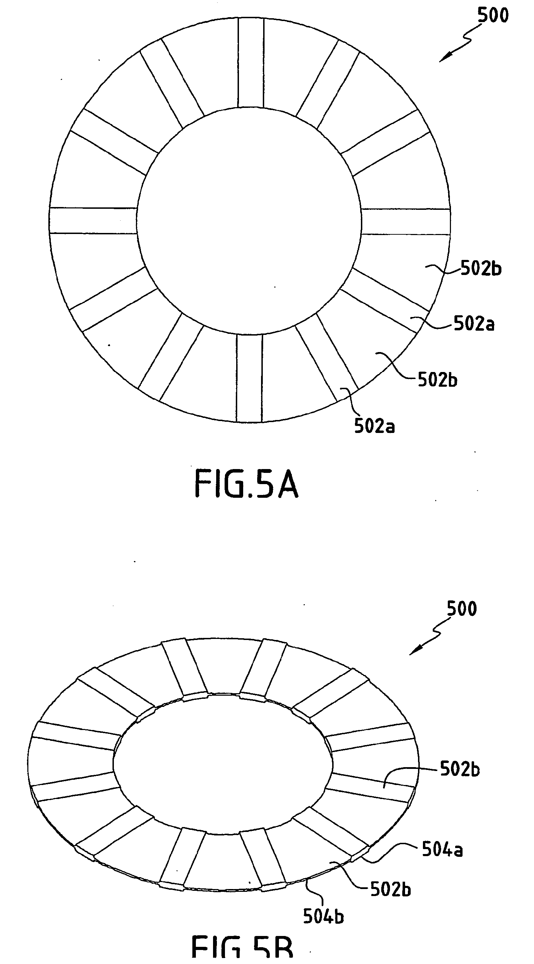

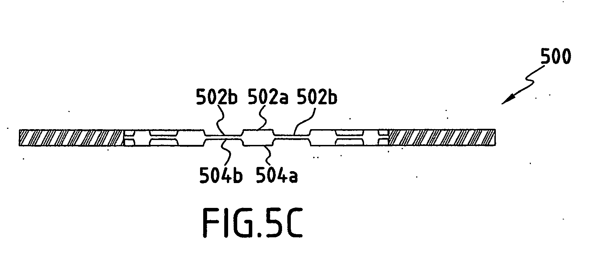

In Figures 5a-5c, Figure 5a is a plan view of an annular shim member 500 according to the present invention. Figure 5b is a perspective view of annular shim member 500. Figure 5c is a cross-sectional elevational view of shim member 500 in a plane perpendicular to a plane in which the annular shim member 500 lies.

Most generally, annular shim member 500 differs from annular shim members 300 and 400 in that, relatively, the raised portions 502a, 504a on the opposite sides of annular shim member 500 are aligned, as are the lowered portions 502b, 504b. See, especially, Figure 5c. As before, the lowered portions 502b, 504b at least partly define channels through which the densification gas can pass between an interior of the stacked annular preforms and an exterior thereof.

In one example, one can consider the manufacture of annular shim member 500 from the perspective of forming corresponding channels 502b, 504b on opposite faces of a carbon (e.g., graphite) blank having an initial thickness at least on the order of the thickness of the annular shim member 500 at locations where the raised portions 502a, 504a correspond.

As mentioned above, the aforementioned geometries can be obtained by any known and appropriate process, especially, but not only, machining or molding or both.

When using carbon materials to manufacture shim members according to the present invention for use with composite carbon annular preforms, there is sometimes a problem of the shim member adhering to the preforms after a densification process. In order to address this issue, the provision of a debonding coating on the surface of the shim member is used in order to help avoid such adhesion.

One example of a useful debonding coating includes a first layer formed on the shim member made from M_{O}Si₂, and a second layer formed on the first layer made from Al₂O₃. These layers can be formed using a known process of plasma spraying, for example. The MoSi₂ layer acts as a bridging layer to improve the adhesion of the Al₂O₃ layer to the structure.

It should be noted that the provision of a carbon-based shim member, especially a graphite shim member, has additional benefits during manufacture. In general, the provision of graphite shim members to the annular preform stack adds to the thermal mass of the stack so as to facilitate heating, and in turn, densification. This is beneficial because it is relatively difficult to raise the temperature of the preforms alone. (In a conventional process, the top and bottom of a stack of preforms have the highest level of densification because of their larger exposure to heating compared to intermediate preforms in the stack.) Also, because of the good thermal conductivity of the carbon shim members, a more uniform temperature distribution can be provided across the radial width of the adjacent annular preforms.

While the present invention has been described with respect to what are believed to be the most practical embodiments thereof, it is particularly noted that this is by way of example only, and appropriate modifications and variations thereof are possible within the scope of the claims appended hereto.

## Claims

1. An annular unitary shim member having first and second opposing surfaces,
wherein the member is made from a carbon material having a debonding coating formed thereon, the member including a plurality of radially extending channels formed on at least one of the first and second surfaces.

2. The member according to claim 1, wherein a plurality of radially extending channels is formed on both of the first and second surfaces.

3. The member according to claim 2, wherein the plurality of channels formed on the first surface is substantially aligned with the plurality of channels formed on the second surface.

4. The member according to claim 2, wherein the plurality of channels formed on the first surface is offset in a circumferential direction from the plurality of channels formed on the second surface.

5. The member according to claim 1, wherein the carbon material is one of a carbon/carbon material and a solid graphite material.

6. The member according to claim 5. wherein the carbon/carbon fiber material is a woven carbon fiber yarn fabric.

7. The member according to claim 1, wherein the debonding coating comprises a first layer of MoSi₂ formed on the carbon material, and a second layer of Al₂O₃ formed on the first layer of MoSi₂.

8. A method of preparing a plurality of annular carbon fiber preforms for a chemical vapor infiltration process, comprising:
stacking the plurality of annular carbon fiber preforms, wherein an annular unitary shim member made from a carbon material is provided between each respective pair of the annular carbon fiber preforms, the stacked plurality of annular carbon fiber preforms and annular unitary shim members collectively defining an interior space within the stack,
wherein each annular unitary shim member has oppositely facing first and second surfaces and a plurality of radially extending channels formed on at least one of said first and second surfaces for communicating the interior space of the stack with an exterior of the stack, each annular unitary shim member being provided with a debonding coating formed thereon for preventing the annular carbon fiber preforms from adhering thereto.

9. The method according to claim 8, wherein each of the first and second surfaces of each annular unitary shim member has a respective plurality of channels formed thereon.

10. The method according to claim 9, wherein the plurality of channels formed on the first surface is substantially aligned with the plurality of channels formed on the second surface.

11. The method according to claim 9, wherein the plurality of channels formed on the first surface is offset in a circumferential direction from the plurality of channels formed on the second surface.

12. The method according to claim 8, wherein the carbon material is one of a carbon/carbon fiber material and a solid graphite material.

13. The method according to claim 12, wherein the carbon/carbon fiber material is a woven carbon fiber yarn fabric.

14. The method according - to claim 8, wherein the debonding coating comprises a first layer of MoSi₂ formed on the carbon material, and a second layer of Al₂O₃ formed on the first layer of MoSi₂.

15. A method for manufacturing a unitary annular shim from a carbon material, the method comprising:
forming an annular member from a carbon material, the annular member having first and second opposing faces and a radially extending channel formed on at least one of the first and second opposing faces; and
forming a debonding coating on the annular member

16. The method according to claim 15, wherein forming the debonding coating comprises forming a first layer of MoSi₂ on the carbon material, and forming a second layer of Al₂O₃ on the first layer of MoSi₂.

17. The method according to claim 16, wherein forming the debonding coating comprises using plasma spraying to form the first layer of MoSi₂ on the carbon material and the second layer of Al₂O₃ on the first layer of MoSi₂.

18. The method according to claim 15, wherein forming an annular member comprises machining a graphite blank.

19. The method according to claim 15, wherein the carbon material is one of a carbon/carbon fiber material and a woven carbon fiber yarn fabric.

20. The method according to claim 8, wherein the provision of the annular unitary shim member made from a carbon material between each respective pair of the annular carbon fiber preforms increases the thermal mass of the stack so as to improve the efficiency of the chemical vapor infiltration process.

21. The method according to claim 8, wherein each annular shim has an outer diameter smaller than an outer diameter of the annular carbon fiber preforms and an inner diameter larger than an inner diameter of the annular carbon fiber preforms.

22. The method according to claim 21, wherein the outer and inner diameters of each annular shim are about 5 mm smaller than and about 5 mm greater than, respectively, the outer and inner diameters of the annular carbon fiber preforms.

## Patentansprüche

1. Ringförmiges einheitliches Ausgleichsscheibenelement mit einer ersten und einer zweiten gegenüberliegenden Fläche, wobei das Element aus einem Kohlenstoffmaterial hergestellt ist, auf dem eine Ablösungsbeschichtung ausgebildet ist, wobei das Element eine Vielzahl von sich radial erstreckenden Kanälen umfaßt, die auf wenigstens einer der ersten und zweiten Flächen ausgebildet sind.

2. Element nach Anspruch 1, bei welchem eine Vielzahl von sich radial erstreckenden Kanälen sowohl an der ersten als auch der zweiten Fläche ausgebildet ist.

3. Element nach Anspruch 2, bei welchem die auf der ersten Fläche ausgebildete Vielzahl von Kanälen im wesentlichen mit der auf der zweiten Fläche ausgebildeten Vielzahl von Kanälen ausgerichtet ist.

4. Element nach Anspruch 2, bei welchem die auf der ersten Fläche ausgebildete Vielzahl von Kanälen in einer Umfangsrichtung zu der auf der zweiten Fläche ausgebildeten Vielzahl von Kanälen versetzt ist.

5. Element nach Anspruch 1, bei weichem das Kohlenstoffmaterial ein Kohlenstoff-/Kohlefasermaterial oder ein festes Graphitmaterial ist.

6. Element nach Anspruch 5, bei welchem das Kohlenstoff-/Kohlefasermaterial ein Kohlefasergarngewebe ist.

7. Element nach Anspruch 1, bei welchem die Ablösungsbeschichtung eine erste Schicht aus MoSi₂, die auf dem Kohlenstoffmaterial ausgebildet ist, und eine zweite Schicht aus Al₂O₃ aufweist, die auf der ersten Schicht aus MoSi₂ ausgebildet ist.

8. Verfahren zum Vorbereiten einer Vielzahl von ringförmigen Kohlefaservorformen für einen Gasphaseninfiltrationsprozeß, umfassend:
Stapeln der Vielzahl von ringförmigen Kohlefaservorformen, wobei ein ringförmiges einheitliches Ausgleichscheibenelement, das aus einem Kohlenstoffmaterial hergestellt ist, zwischen jedem Paar der ringförmigen Kohlefaservorformen vorgesehen wird, wobei die gestapelte Vielzahl von ringförmigen Kohlefaservorformen und ringförmige einheitliche Vorformen gemeinsam einen Innenraum in dem Stapel definieren,
wobei jedes ringförmige einheitliche Ausgleichscheibenelement entgegengesetzt gewandte erste und zweite Flächen und eine Vielzahl von sich radial erstreckenden Kanälen hat, die wenigstens auf einer der ersten und zweiten Flächen ausgebildet sind, um den Innenraum des Stapels mit außerhalb des Stapels in Verbindung zu bringen, wobei jedes ringförmige einheitliche Ausgleichsscheibenelement mit einer darauf ausgebildeten Ablösungsbeschichtung versehen ist, um zu verhindern, daß die ringförmigen Kohlefaservorformen daran haften.

9. Verfahren nach Anspruch 8, bei welchem auf jeder der ersten und zweiten Flächen jedes ringförmigen einheitlichen Ausgleichsscheibenelements eine Vielzahl von Kanälen ausgebildet ist.

10. Verfahren nach Anspruch 9, bei welchem die auf der ersten Fläche ausgebildete Vielzahl von Kanälen im wesentlichen mit der auf der zweiten Fläche ausgebildeten Vielzahl von Kanälen ausgerichtet ist.

11. Verfahren nach Anspruch 9. bei welchem die auf der ersten Fläche ausgebildete Vielzahl von Kanälen in einer Umfangsrichtung zu der auf der zweiten Fläche ausgebildeten Vielzahl von Kanälen versetzt ist.

12. Verfahren nach Anspruch 8, bei welchem das Kohlenstoffmaterial ein Kohlenstoff-/Kohlefasermaterial oder ein festes Graphitmaterial ist.

13. Verfahren nach Anspruch 12, bei welchem das Kohlenstoff-/Kohlefasermaterial ein Kohlefasergarngewebe ist,

14. Verfahren nach Anspruch 8, bei welchem die Ablösungsbeschichtung eine erste Schicht aus MoSi₂, die auf dem Kohlenstoffmaterial ausgebildet ist, und eine zweite Schicht aus Al₂O₃ aufweist, die auf der ersten Schicht aus MoSi₂ ausgebildet ist.

15. Verfahren zum Herstellen eines einheitlichen ringförmigen Ausgfeichscheibenelements aus einem Kohlenstoffmaterial, wobei das Verfahren umfaßt:
Ausbilden eines ringförmigen Elements aus einem Kohlenstoffmaterial, wobei das ringförmige Element erste und zweite gegenüberliegende Seiten und einen sich radial erstreckenden Kanal hat, der auf wenigstens einer der ersten und zweiten gegenüberliegenden Seiten ausgebildet ist: und
Ausbilden einer Ablösungsbeschichtung auf dem ringförmigen Element.

16. Verfahren nach Anspruch 15, bei welchem das Ausbilden der Ablösungsbeschichtung umfaßt, daß eine erste Schicht aus MoSi₂ auf dem Kohlenstoffmaterial ausgebildet wird und eine zweite Schicht aus Al₂O₃ auf der ersten Schicht aus MoSi₂ ausgebildet wird,

17. Verfahren nach Anspruch 16, bei welchem das Ausbilden der Ablösungsbeschichtung umfaßt, daß Plasmasprühen verwendet wird, um die erste Schicht aus MoSi₂ auf dem Kohlenstoffmaterial und die zweite Schicht aus Al₂O₃ auf der ersten Schicht aus MoSi₂ auszubilden.

18. Verfahren nach Anspruch 15, bei welchem das Ausbilden eines ringförmigen Elements die Bearbeitung eines Graphitrohlings umfaßt.

19. Verfahren nach Anspruch 15, bei welchem das Kohlestoffmaterial ein Kohlenstofi-/Kohlefasermaterial oder ein Kohlefasergarngewebe ist.

20. Verfahren nach Anspruch 8, bei welchem das Vorsehen des aus einem Kohlenstoffmaterial hergestellten ringförmigen einheitlichen Ausgleichscheibenelements zwischen jedem Paar der ringförmigen Kohlefaservorformen die thermische Masse des Stapels erhöht, so daß der Wirkungsgrad des Gasphaseninfiltrationsprozesses verbessert wird.

21. Verfahren nach Anspruch 8, bei welchem jede ringförmige Ausgleichsscheibe einen Außendurchmesser, der kleiner als ein Außendurchmesser der ringförmigen Kohlefaservorformen ist, und einen Innendurchmesser hat, der größer als ein Innendurchmesser der ringförmigen Kohlefaservorformen ist.

22. Verfahren nach Anspruch 21, bei welchem die Außen- und Innendurchmesser jeder ringförmigen Ausgleichscheibe etwa 5 mm kleiner bzw. etwa 5 mm größer als die Außen- und Innendurchmesser der ringförmigen Kohlefaservorformen sind.

## Revendications

1. Elément de cale unitaire annulaire ayant des première et seconde surfaces opposées,
dans lequel l'élément est constitué à partir d'un matériau carbone sur lequel est formé un revêtement de décollage, l'élément comprenant une pluralité de canaux d'extension radiale formée sur au moins l'une des première et seconde surfaces.

2. Elément selon la revendication 1, dans lequel une pluralité de canaux d'extension radiale est formée sur chacune des première et seconde surfaces.

3. Elément selon la revendication 2, dans lequel la pluralité de canaux formés sur la première surface est sensiblement alignée avec la pluralité de canaux formés sur la seconde surface.

4. Elément selon la revendication 2, dans lequel la pluralité de canaux formés sur la première surface est décalée dans une direction circonférentielle par rapport à la pluralité de canaux formés sur la seconde surface.

5. Elément selon la revendication 1, dans lequel le matériau carbone est l'un parmi un matériau carbone/carbone et un matériau graphite solide.

6. Elément selon la revendication 5, dans lequel le matériau de fibres de carbone/carbone est un tissu de fil de fibres de carbone tissé.

7. Elément selon la revendication 1, dans lequel le revêtement de décollage comprend une première couche de MoSi₂ formée sur le matériau carbone et une seconde couche de Al₂O₃ formée sur la première couche de MoSi₂.

8. Procédé de préparation d'une pluralité de préformes de fibres de carbone annulaires pour un procédé d'infiltration chimique en phase vapeur, comprenant l'étape consistant à :
empiler la pluralité de préformes de fibres de carbone annulaires, où un élément de cale unitaire annulaire constitué à partir d'un matériau carbone est disposé entre chaque paire respective des préformes de fibres de carbone annulaires, la pluralité empilée de préformes de fibres de carbone annulaires et les éléments de cale unitaire annulaires définissant collectivement un espace intérieur dans la pile,
dans lequel chaque élément de cale unitaire annulaire a des première et seconde surfaces opposées et une pluralité de canaux d'extension radiale formés sur au moins l'une desdites première et seconde surfaces pour faire communiquer l'espace intérieur de la pile avec l'extérieur de la pile, chaque élément de cale unitaire annulaire étant doté d'un revêtement de décollage formé dessus pour empêcher les préformes de fibres de carbone annulaires d'adhérer à celui-ci.

9. Procédé selon la revendication 8, dans lequel chacune des première et seconde surfaces de chaque élément de cale unitaire annulaire a une pluralité respective de canaux formés dessus.

10. Procédé selon la revendication 9, dans lequel la pluralité de canaux formés sur la première surface est sensiblement alignée avec la pluralité de canaux formés sur la seconde surface.

11. Procédé selon la revendication 9, dans lequel la pluralité de canaux formés sur la première surface est décalée dans une direction circonférentielle par rapport à la pluralité de canaux formés sur la seconde surface.

12. Procédé selon la revendication 8, dans lequel le matériau carbone est l'un parmi un matériau de fibres de carbone/carbone et un matériau graphite solide.

13. Procédé selon la revendication 12, dans lequel le matériau de fibres de carbone/carbone est un tissu de fil de fibres de carbone tissé.

14. Procédé selon la revendication 8, dans lequel le revêtement de décollage comprend une première couche de MoSi₂ formée sur le matériau carbone et une seconde couche de Al₂O₃ formée sur la première couche de MoSi₂.

15. Procédé de fabrication d'une cale annulaire unitaire formée à partir d'un matériau carbone, le procédé comprenant les étapes consistant à :
former un élément annulaire à partir d'un matériau carbone, l'élément annulaire ayant des première et seconde faces opposées et un canal d'extension radiale formé sur au moins l'une des première et seconde faces opposées ; et
former un revêtement de décollage sur l'élément annulaire.

16. Procédé selon la revendication 15, dans lequel la formation du revêtement de décollage comprend la formation d'une première couche de MoSi₂ sur le matériau carbone et la formation d'une seconde couche de Al₂O₃ sur la première couche de MoSi₂.

17. Procédé selon la revendication 16, dans lequel la formation du revêtement de décollage comprend l'utilisation de la pulvérisation par plasma pour former la première couche de MoSi₂ sur le matériau carbone et la seconde couche de Al₂O₃ sur la première couche de MoSi₂.

18. Procédé selon la revendication 15, dans lequel la formation d'un élément annulaire comprend l'usinage d'une ébauche de graphite.

19. Procédé selon la revendication 15, dans lequel le matériau carbone est l'un parmi un matériau de fibres de carbone/carbone et un tissu de fil de fibres de carbone tissé.

20. Procédé selon la revendication 8, dans lequel la disposition de l'élément de cale unitaire annulaire constitué à partir d'un matériau carbone entre chaque paire respective des préformes de fibres de carbone annulaires augmente la masse thermique de la pile de sorte à améliorer le rendement du procédé d'infiltration chimique en phase vapeur.

21. Procédé selon la revendication 8, dans lequel chaque cale annulaire a un diamètre externe plus petit qu'un diamètre externe des préformes de fibres de carbone annulaires et un diamètre interne plus grand qu'un diamètre interne des préformes de fibres de carbone annulaires.

22. Procédé selon la revendication 21, dans lequel les diamètres externe et interne de chaque cale annulaire sont plus petits d'environ 5 mm et plus grands d'environ 5 mm, respectivement, que les diamètres externe et interne des préformes de fibres de carbone annulaires.
